# EUROPÄISCHE PATENTSCHRIFT

(11) **EP 4 229 698 B1**
(45) Veröffentlichungstag und Bekanntmachung des Hinweises auf die Patenterteilung: **28.05.2025**
(21) Anmeldenummer: 21794520.3
(22) Anmeldetag: 14.10.2021
(51) Int. Cl.: H01M 8/04537, G01R 15/22, H01M 8/0202, H01M 8/04664, H01M 8/242, H01M 8/10

(54) **VORRICHTUNG ZUR ÜBERWACHUNG DER ZELLSPANNUNG**
APPARATUS FOR MONITORING THE CELL VOLTAGE
APPAREIL DE SURVEILLANCE DE LA TENSION DE CELLULE

(30) Priorität: 15.10.2020 DE 102020006353
(43) Veröffentlichungstag der Anmeldung: 23.08.2023
(73) Patentinhaber: cellcentric GmbH & Co. KG, 73230 Kirchheim unter Teck (DE)
(72) Erfinder: HAUSMANN, Philipp, 73230 Kirchheim (DE); KÖLMEL, Marc, 73230 Kirchheim (DE); PIECK, Benjamin, 73230 Kirchheim (DE)
(74) Vertreter: Platzöder Patentanwaltsgesellschaft mbH
(86) Internationale Anmeldenummer: PCT/EP2021/078535
(87) Internationale Veröffentlichungsnummer: WO 2022/079210

(56) Entgegenhaltungen:
- DE-A1- 102007 015 735
- DE-A1- 102011 012 815
- JP-A- 2005 141 936
- US-B2- 8 445 152

## Beschreibung

Die Erfindung betrifft eine Vorrichtung zur Überwachung der Zellspannung von durch eine Membranelektrodenanordnung und Bipolarplatten gebildeten Einzelzelle eines Brennstoffzellenstapels nach der im Oberbegriff von Anspruch 1 näher definierten Art. Die Überwachung der Zellspannungen von Einzelzellen eines Brennstoffzellenstapels ist prinzipiell aus dem Stand der Technik bekannt. Diese wird häufig mit dem englischen Begriff Cell Voltage Measurement (CVM) bezeichnet oder abgekürzt. Bei Brennstoffzellenstapeln, wie sie beispielsweise in Fahrzeugen Anwendung finden, ist eine solche CVM relativ aufwändig, teuer und verursacht einen erheblichen Bedarf an Bauraum. Außerdem müssen die elektrischen Kontakte von typischerweise 200 bis 400 Einzelzellen je Brennstoffzellenstapel abgegriffen und gegebenenfalls herausgeführt werden, um die Messungen zuverlässig vornehmen zu können. Darüber hinaus ist der gesamte Aufbau in einer Hochvoltumgebung angeordnet und muss entsprechend sicher ausgeführt sein, beispielsweise hinsichtlich des Isolationswiderstands, der Spannungsfestigkeit sowie Schleich- und Kriechstrecken. Darüber hinaus ist es so, dass der Aufbau typischerweise innerhalb des Gehäuses um den Brennstoffzellenstapel angeordnet ist. Da es hier zu Wasserstoffansammlung aufgrund von Permeation und Leckage kommen kann, muss auf einen besonderen Explosionsschutz geachtet werden. Ferner ist es so, dass der gesamte Aufbau in einer hinsichtlich der elektrochemischen Korrosion anspruchsvollen Umgebung ist.

Um diesen Problemen Herr zu werden, schlägt nun die DE 10 2007 015 735 A1 eine optische Zellspannungsüberwachungseinrichtung für Brennstoffzellenstapel vor. In einer Messeinrichtung, welche zwischen den Bipolarplatten von Einzelzellen fixiert ist, ist jeweils die optische Vorrichtung angeordnet, um ein optisches Signal der gemessenen Spannung zu generieren. Diese optischen Signale werden dann in der Art eines Optokopplers von den jeweiligen Signalquellen zugeordneten Sensoren bzw. Detektoren aufgenommen, um so die innerhalb des Brennstoffzellenstapels erfassten Messwerte der Spannungen der Einzelzellen in die äußere Umgebung des Brennstoffzellenstapels zu übertragen. Dabei können hochauflösende Detektoren eingesetzt werden, wobei durch die Verwendung von Spiegeln die Anzahl der Detektoren reduziert werden kann.

US 8445152 B2 beschreibt eine Vorrichtung zur Überwachung der Spannung einer Einzelzelle eines Brennstoffzellenstapels, wobei jeder Einzelzelle eine Messeinrichtung auf einer flexiblen Platine zugeordnet ist, welche mit einem Rahmen einer gerahmten Membranelektrodenanordnung verbunden ist.

Der Aufbau ist immer noch relativ aufwändig und komplex, insbesondere aufgrund der Anordnung zwischen den Bipolarplatten sowie der Anbindung an diese. Außerdem sind hochauflösende Detektoren zur Signalverarbeitung notwendig, welche einerseits fehleranfällig und andererseits aufwändig und teuer sind.

Die Aufgabe der hier vorliegenden Erfindung besteht nun darin, eine verbesserte Vorrichtung zur Überwachung der Zellspannung gemäß dem Oberbegriff des Anspruchs 1 anzugeben, welche den genannten Stand der Technik vorteilhaft weiterbildet.

Erfindungsgemäß wird diese Aufgabe durch eine Vorrichtung mit den Merkmalen im Anspruch 1, und hier insbesondere im kennzeichnenden Teil des Anspruchs 1, gelöst. Vorteilhafte Ausgestaltungen und Weiterbildungen der erfindungsgemäßen Vorrichtung ergeben sich aus den hiervon abhängigen Unteransprüchen.

Die erfindungsgemäße Vorrichtung sieht es, ähnlich wie im eingangs genannten Stand der Technik beschrieben, vor, dass jeder Einzelzelle eine Messeinrichtung mit einem optischen Signalgeber zugeordnet ist. Erfindungsgemäß ist es nun so, dass die Messeinrichtung auf einer flexiblen Platine ausgebildet ist, welche mit einem Rahmen einer gerahmten Membranelektrodenanordnung, einer sogenannten MEFA (Membran Electrode Framed Assembly) verbunden oder aus als Teil derselben ausgebildet ist. Diese MEFA spielt bei heutigen Brennstoffzellenstapeln eine ganz entscheidende Rolle. Bereits bei der Herstellung der Elektroden, der katalytisch beschichteten Membran und der Gasdiffusionslagen wird dieser Aufbau komplettiert, welcher dann beispielsweise mit einer eigenen Dichtung versehen und dann als SMEFA bezeichnet zwischen zwei Bipolarplatten eingelegt wird, wenn der Brennstoffzellenstapel aufgestapelt wird. Die Alternative sieht es vor, dass die Dichtungen entsprechend mit den Bipolarplatten verbunden sind oder prinzipiell auch während des Aufstapelns eingelegt werden. Ungeachtet dessen ist es so, dass eine flexible Platine im Bereich des Rahmens außerordentlich einfach und effizient ist und diesen zum Teil auch ausbilden kann. Derartige Platinen können verschiedene Funktionalitäten umfassen, bei dem erfindungsgemäßen Aufbau zumindest Messeinrichtung mit dem von ihr ansteuerbaren optischen Signalgeber.

Der Aufbau wird dadurch außerordentlich einfach und in der Montage sehr effizient. Die flexible Platine benötigt dabei innerhalb des Brennstoffzellenstapels quasi keinen von anderen Komponenten belegten Bauraum, sodass die Vorrichtung zur Überwachung der Zellspannungen der Einzelzellen annähernd Bauraumneutral ausgebildet werden kann. Über die Verwendung eines optischen Signalgebers, welcher, wie es prinzipiell aus dem Stand der Technik bekannt ist, mit wenigstens einem optischen Sensor in der Art eines Optokopplers zusammenwirkt, lassen sich außerdem die Anforderungen an die elektrische Sicherheit und den Explosionsschutz problemlos erfüllen.

Gemäß einer außerordentlich günstigen Weiterbildung der erfindungsgemäßen Vorrichtung kann die Messeinrichtung dabei über flexible Leiter und/oder besonders bevorzugt über Federkontakte mit den beiden benachbarten Bipolarplatten elektrisch verbunden sein. Eine solche Anbindung über flexible Leiter, welche eine Leiterschleife zwischen der flexiblen Platine mit der Messeinrichtung und der Bipolarplatte ausbilden, ist entsprechend einfach und erlaubt eine im Betrieb unvermeidliche Längenausdehnung des Brennstoffzellenstapels, sei es aufgrund sich ändernder Drücke und/oder Temperaturen. Die Verwendung von Federkontakten zwischen der Messeinrichtung bzw. der mit ihr versehenen flexiblen Platine und dem benachbarten Bipolarplatten erlaubt ähnliches. Darüber hinaus ist die Variante mit den Federkontakten auch in der Montage besonders einfach, da auf eine Kontaktierung der Messeinrichtung nicht speziell geachtet werden muss, sondern da diese sich beim Aufstapeln der Elemente des Brennstoffzellenstapels ohnehin selbsttätig ergibt, während beim Einsatz von flexiblen Leitern diese noch angebunden. beispielsweise angelötet werden müssten.

Die Messeinrichtung selbst kann dabei in an sich bekannter Art und Weise ausgebildet sein. Sie umfasst gemäß einer besonders günstigen Ausgestaltung der erfindungsgemäßen Vorrichtung in jedem Fall einen Hochsetzsteller. Ein solcher Hochsetzsteller ist nun in der Lage, die relativ niedrige Spannung der Einzelzellen entsprechend hochzusetzen, um den optischen Signalgeber, welcher beispielsweise eine oder mehrere LEDs umfassen kann, effizient anzusteuern. Die Leistungsversorgung erfolgt dabei aus der jeweiligen Zelle selbst, sodass keine weiteren Maßnahmen bezüglich der Anbindung des Aufbaus notwendig sind.

Die Zellspannung als physikalische Eingangsgröße für die Messeinrichtung liegt dabei bei jeder Einzelzelle zwischen 0 und typischerweise 1,23 V. Über einen entsprechenden Hochsetzsteller, welcher vorzugsweise als Teil eines integrierten Schaltkreises ausgebildet ist, sowie über einen Schwingkreis als Takt- bzw. Frequenzgeber kann über den Hochsetzsteller als DC/DC-Hochsetzsteller diese Zellspannung, welche typischerweise oberhalb von 0,6 V liegt, entsprechend hochgesetzt werden, beispielsweise auf ein Spannungsniveau von 2,4 bis 4 V, um so LEDs des optischen Signalgebers entsprechend anzusteuern, insbesondere auch Multicolor-LEDs oder mehrere LEDs in unterschiedlichen Helligkeiten, Farben, Blinkfrequenzen oder dergleichen, wobei all dies genutzt werden kann, um die Spannung der überwachten Einzelzelle beispielsweise über einen CCD oder CIS Sensor berührungslos zu empfangen und für eine Steuerung des Brennstoffzellenstapels entsprechend auszuwerten.

Der optische Signalgeber ist dabei gemäß einer sehr vorteilhaften Weiterbildung der erfindungsgemäßen Vorrichtung in der Art ausgebildet, dass er von der Messeinrichtung in sich unterscheidenden Zuständen ansteuerbar ist, wobei die Ansteuerbarkeit vorzugsweise vier sich unterscheidende Zustände umfasst. Ein erster dieser Zustände, und dies ist im Idealfall der Normalzustand, kann es sein, dass der optische Signalgeber ausgeschaltet bleibt. Ist also kein optisches Signal aktiv, dann arbeitet die Zelle im vorgegebenen Soll-Bereich. Kommt es zu Problemen wie beispielsweise einer zu niedrigen Spannung, was im Allgemeinen als Low Cell bezeichnet wird, zu einer zu hohen Spannung (High Cell) oder noch gravierender, kommt es zu einer Umkehrung der Polarität der Einzelzelle (Cell Reversal), dann wird über die Messeinrichtung der optische Signalgeber entsprechend aktiviert. Die typische Spannung für eine Low Cell liegt bei weniger als 600 mV der Einzelzelle im Betrieb, die einer High Cell bei mehr als etwa 825 mV. Ein Cell Reversal liegt vor, wenn die Einzelzelle -10 mV bis -800mV liefert, meist in etwa -600 mV.

Ein aktivierter optischer Signalgeber zeigt also ein Problem mit der jeweiligen Einzelzelle und damit faktisch mit dem die Einzelzelle umfassenden Brennstoffzellenstapel auf. Im Idealfall lässt sich durch mindestens zwei verschiedene Zustände des optischen Signalgebers im eingeschalteten Zustand auch noch der Unterschied visualisieren, sodass anhand des optischen Signalgebers erkannt werden kann, ob die Einzelzelle normal arbeitet, der optische Signalgeber also ausgeschaltet ist, ob der optische Signalgeber eingeschaltet ist, weil die Zelle zu viel oder zu wenig Spannung liefert, oder ob dieser eingeschaltet ist, weil die Einzelzelle ihre Polarität umgekehrt hat, was typischerweise auch als Cell Reversal bezeichnet wird. Das Cell Reversal ist dabei der wichtigste anzuzeigende Zustand, gefolgt von den Low Cells. Die zu hohe Spannung, welche typischerweise auch als High Cell bezeichnet wird, ist der am wenigsten kritische Zustand.

Der einfachste Fall wäre also eine Anzeige eines wie auch immer gearteten Problems, gefolgt von der Unterscheidung der Probleme in Problem und Cell Reversal, sodass also die High Cells und die Low Cells in einem Zustand zusammengefasst werden oder besonders bevorzugt die Anzeige aller drei Zustände explizit, wenn dies hinsichtlich des Aufwands und des Bauraums einfach möglich ist.

Zur Darstellung der einzelnen Zustände lassen sich dabei verschiedene an sich bekannte Möglichkeiten nutzen. So können beispielsweise bei einer oder mehreren einfarbigen Lichtquellen des optischen Signalgebers verschiedene Blinkfrequenzen oder dergleichen zur Unterscheidung der Zustände genutzt werden. Besonders bevorzugt können jedoch verschiedene Farben eingesetzt werden.

Gemäß einer außerordentlich günstigen Ausgestaltung der erfindungsgemäßen Vorrichtung kann es dabei vorgesehen sein, dass der optische Signalgeber jeder Messeinrichtung durch eine lichtemittierende Diode (LED) ausgebildet ist, welche wenigstens zwei, vorzugsweise drei, Lichtfarben abstrahlen kann. Die lichtemittierende Diode kann also insbesondere als sogenannte Multicolor-LED ausgebildet werden. Je nach Zustand kann diese dann ausgeschaltet bleiben, was dem Normalzustand der Einzelzelle entspricht, oder kann eine erste Farbe abstrahlen, beispielsweise weiß, was einer verringerten Spannung der Einzelzelle entspräche oder beispielsweise rot, was einer Umkehr der Polarisierung der Einzelzelle entspräche. Optional kann z.B. blau eine zu hohe Spannung der Einzelzelle anzeigen.

Eine alternative Ausgestaltung hierzu kann es auch vorsehen, dass der optische Signalgeber jeder Messeinrichtung wenigstens zwei lichtemittierende Dioden aufweist. Die zwei oder vorzugsweise drei lichtemittierenden Dioden des optischen Signalgebers können dabei beide die gleiche Farbe abstrahlen, was jedoch die Auswertung über zwei verschiedene optische Sensoren erforderlich macht, oder sie können gemäß einer besonders günstigen Weiterbildung der erfindungsgemäßen Vorrichtung auch unterschiedliche Farben abstrahlen. In diesem Fall ist ein einziger optischer Sensor grundlegend ausreichend, wenn dieser über eine entsprechende Auswerteelektronik verfügt, welche beim Einsatz von Multicolor-LEDs in den optischen Signalgebern zwischen verschiedenen erzeugten Lichtfarben unterscheiden kann, beispielsweise in dem er die aufgenommenen Signale einer Fourier-Analyse unterzieht.

Über mehrere getrennt ausgebildete LEDs lassen sich unterschiedliche Lichtfarben also auch einfach und effizient generieren, je nach Anforderungen kann dies die einfachere und kostengünstigere Variante sein als die Verwendung aufwändigerer Multicolordioden, benötigt aber den Bauraum für mehrere lichtemittierende Dioden, sodass je nach Situation die eine oder die andere Variante von Vorteil sein kann.

Ungeachtet der beiden Varianten wird letzten Endes ein Licht erzeugt, welches bevorzugt über verschiedene Farben im eingeschalteten Zustand auf verschiedene Probleme der jeweiligen Einzelzelle hinweist. Dabei ist es nun möglich, mit entsprechenden optischen Sensoren an jeden einzelnen optischen Signalgeber der Vielzahl von Messeinrichtungen einzeln oder in der im eingangs beschriebenen Stand der Technik gezeigten Art über einen Spiegel und einen hochauflösenden Sensor entsprechend abzufragen. In der Praxis ist es häufig jedoch völlig egal, welche der Einzelzellen eines Brennstoffzellenstapels die entsprechenden Probleme verursacht, da typischerweise mit einer den ganzen Brennstoffzellenstapel betreffenden Reaktion gegensteuert werden muss, oder dieser als Ganzes beispielsweise abgeschaltet werden muss, um eine weitere Beschädigung zu vermeiden, da das Abschalten von Einzelzellen in der Praxis nicht möglich ist.

Eine außerordentlich günstige und kosteneffiziente Weiterbildung der erfindungsgemäßen Vorrichtung sieht es deshalb vor, dass die Signale aller optischen Signalgeber des Brennstoffzellenstapels über wenigstens einen Lichtleiter mit wenigstens einem optischen Sensor verbunden sind. Diese besonders günstige Ausgestaltung der Erfindung kann also die Verwendung von Lichtleitern vorsehen. Prinzipiell könnte nun jede einzelne lichtemittierende Diode bzw. jede Lichtquelle der einzelnen optischen Signalgeber mit einem eigenen Lichtleiter versehen werden, welcher das Licht zu einem gemeinsamen optischen Sensor oder auch einer geringen Anzahl von optischen Sensoren herausführt. Besonders einfach und effizient wird der Aufbau jedoch dann, wenn wenigstens ein streifenförmiger Lichtleiter eingesetzt wird, und zwar in der Art, dass, gemäß einer vorteilhaften Ausgestaltung der erfindungsgemäßen Vorrichtung, die optischen Signalgeber ihr Licht in eine der Längsseiten des streifenförmigen Lichtleiters einkoppeln und der wenigstens eine optische Sensor an wenigstens einer der Stirnseiten dieses streifenförmigen Lichtleiters angeordnet ist.

Ein einziger Lichtleiter, welcher beispielsweise in Stapelrichtung entlang des Brennstoffzellenstapels verläuft, und in welchem die optischen Signalgeneratoren jeder der Messeinrichtungen für den Fall, dass sie aktiviert sind, Licht einsteuern, kann dann ausreichen, um zum Beispiel mit einem einzigen optischen Sensor alle Signalgeber gleichzeitig anzusteuern. Über einen solchen Lichtleiter lässt sich dann mit dem einen optischen Sensor also ein Problem innerhalb des Stapels erkennen. Ist die Reaktion ein Abschalten des Stapels, dann reicht dies vollständig aus und erlaubt es, die bisher anfallenden Kosten für eine Einzelzellspannungsüberwachung deutlich zu reduzieren.

Gemäß einer außerordentlich günstigen Weiterbildung der Idee kann dem optischen Sensor dabei eine Auswerteelektronik zugeordnet sein, welche dazu eingerichtet ist, Farben zu unterscheiden. So kann beispielsweise über eine Fourier-Analyse der durch den optischen Sensor aufgenommenen Daten eine rote Lichtfarbe herausgefiltert werden, wenn diese im entsprechenden Maß auftritt. Damit kann auch über einen einzigen Sensor und gegebenenfalls mehrere aktive optische Signalgeber von mehreren Einzelzellen detektiert werden, ob eine oder alle der Einzelzellen unter dem Problem "Low Cell" oder "High Cell" leiden oder ob eine oder mehrere darunter eine Umkehr der Polarisierung als Problem haben.

Dies funktioniert dabei sowohl bei einer einzigen Multicolor-LED, welche verschiedene Farben erzeugen kann, als auch bei der Verwendung von verschiedenfarbigen LEDs, welche beide ihr Licht in ein und denselben Lichtleiter einstrahlen.

Eine alternative Ausgestaltung der Variante mit den wenigstens zwei getrennten LEDs mit vorzugsweise verschiedenen Lichtfarben kann es darüber hinaus vorsehen, dass wenigstens zwei beispielsweise parallel angeordnete streifenförmige Lichtleiter vorhanden sind, während die einzelnen LEDs des optischen Signalgenerators ebenfalls beispielsweise nebeneinander und quer zur Stapelrichtung versetzt angeordnet sind. Über zwei oder drei entlang des Stapels verlaufende Lichtleiter kann dann einerseits das Licht der einen LED und andererseits das Licht der anderen LED gezielt in den Bereich eines der Enden des Stapels geleitet werden. Über einen Sensor je Lichtleiter lässt sich dann die eine oder die andere LED und damit ohne aufwändige Softwareanalyse der eine oder der andere Zustand, also ein Vorhandensein wenigstens einer Low Cell, einer High Cell oder das Vorhandensein wenigstens einer in ihrer Polarität umgekehrten Zelle detektieren.

Je nach Anzahl der Einzelzellen und Länge des Brennstoffzellenstapels kann es dabei gegebenenfalls auch von Vorteil sein, und dies ist auch für die oben beschriebene Ausgestaltungsvariante mit einem streifenförmigen Lichtleichter möglich, dass an jedem der Enden des Brennstoffzellenstapels, also an zwei Stirnseiten des Lichtleiters, jeweils ein optischer Sensor angeordnet wird, um so die Zuverlässigkeit bei geringer Lichtausbeute im Bereich der optischen Sensoren zu steigern.

Weitere vorteilhafte Ausgestaltungen der erfindungsgemäßen Vorrichtung ergeben sich auch aus dem Ausführungsbeispiel, welches unter Bezugnahme auf die Figuren näher dargestellt ist.

Dabei zeigen:
- Fig. 1: eine schematische Darstellung eines Brennstoffzellenstapels;
- Fig. 2: einen Ausschnitt aus einem Brennstoffzellenstapel mit der erfindungsgemäßen Vorrichtung;
- Fig. 3: eine Darstellung analog zu der in Fig. 1 mit einer besonders günstigen Ausgestaltung der erfindungsgemäßen Vorrichtung;
- Fig. 4: eine Darstellung einer möglichen Ausgestaltung der erfindungsgemäßen Vorrichtung anhand eines Ausschnitts des Brennstoffzellenstapels und der Vorrichtung in einer ersten möglichen Ausführungsform;
- Fig. 5: eine Darstellung einer möglichen Ausgestaltung der erfindungsgemäßen Vorrichtung anhand eines Ausschnitts des Brennstoffzellenstapels und der Vorrichtung in einer zweiten möglichen Ausführungsform;
- Fig. 6: eine Darstellung einer möglichen Ausgestaltung der erfindungsgemäßen Vorrichtung anhand eines Ausschnitts des Brennstoffzellenstapels und der Vorrichtung in einer dritten möglichen Ausführungsform; und
- Fig. 7: eine Darstellung einer möglichen Ausgestaltung der erfindungsgemäßen Vorrichtung anhand eines Ausschnitts des Brennstoffzellenstapels und der Vorrichtung in einer vierten möglichen Ausführungsform.

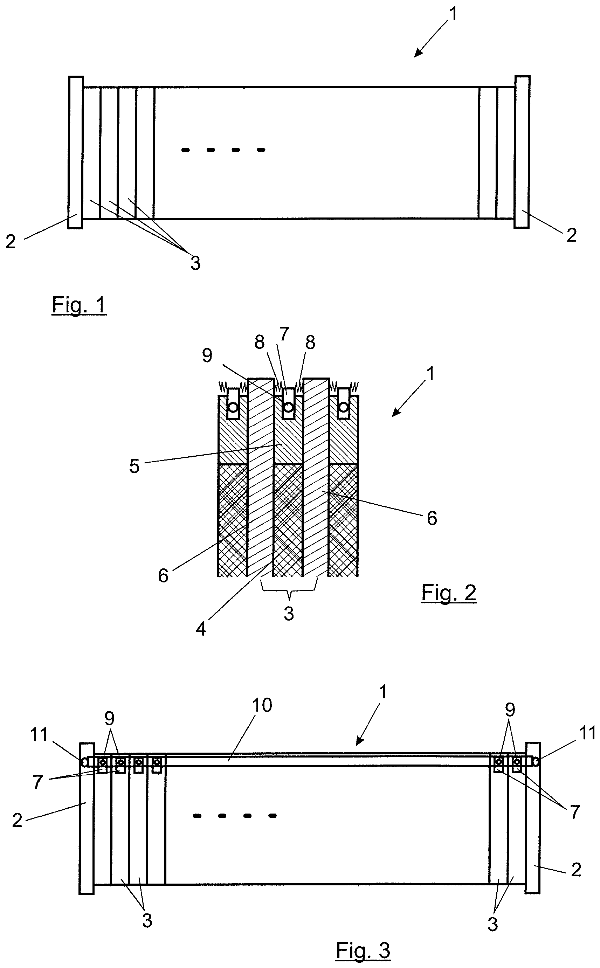

In der Darstellung der Figur 1 ist ganz allgemein ein mit 1 bezeichneter Brennstoffzellenstapel gezeigt. Zwischen zwei jeweils mit 2 bezeichneten Endplatten befinden sich dabei eine Vielzahl von mit 3 bezeichneten Einzelzellen, von welchen hier einerseits nicht alle dargestellt und andererseits nicht alle dargestellten mit einem Bezugszeichen versehen sind. Dem Fachmann ist der Aufbau eines solchen Brennstoffzellenstapels 1 bekannt. Bei dem hier dargestellten Brennstoffzellenstapel 1 soll es sich um eine Niedertemperaturbrennstoffzelle mit PEM-Einzelzellen, also Zellen mit einer katalytisch beschichteten protonenleitenden Membran handeln.

In der Darstellung der Figur 2 ist ein Ausschnitt des Brennstoffzellenstapels in einer vergrößerten Darstellung gezeigt. Die dabei gezeigte mittlere Einzelzelle 3, von welcher lediglich ein oberer Teil dargestellt ist, umfasst eine sogenannten Membranelektrodenanordnung 4, welche einerseits die katalytisch beschichtete Membran und andererseits die Gasdiffusionslagen und Elektroden umfasst. Diese Membranelektrodenanordnung ist hier mit einem Rahmen 5 verklebt. Dieser Aufbau wird auch als gerahmte Membranelektrodenanordnung oder Membrane Electrode Frame Assembly (MEFA) bezeichnet. Diese MEFA 4, 5 kann dabei mit eigenen Dichtungen versehen sein, welche hier nicht dargestellt sind. Sie wird dann als SMEFA bezeichnet. Alternativ dazu können die Dichtungen auch beim Aufstapeln eingelegt werden oder sind in den jeweils benachbart zur MEFA 4, 5 angeordneten Bipolarplatten 6 angeordnet. Von diesen Bipolarplatten 6 sind hier zwei in der Darstellung der Figur 2 dargestellt. Sie weisen auf ihrer einen Seite ein hier nicht dargestelltes Strömungsfeld zur Verteilung von wasserstoffhaltigen Gasen auf der anderen Seite ein hier nicht dargestelltes Strömungsfeld zur Verteilung von sauerstoffhaltigem Gas auf die beiden benachbarten Einzelzellen auf. Typischerweise ist dazwischen im Inneren der Bipolarplatte 6 ein Strömungsfeld für Kühlmedium angeordnet. All dies ist dem Fachmann für Brennstoffzellen bekannt. Die Bipolarplatten 6 können sowohl metallisch als auch aus mit elektrisch leitenden Füllstoffen versehenen Kunststoffen oder elektrisch leitend beschichteten Kunststoffmaterialien hergestellt werden. All dies ist für die hier vorliegende Erfindung von untergeordneter Bedeutung, sodass hierauf nicht weiter eingegangen wird.

In Verbindung mit oder als Teil des Rahmens 5 ist dabei eine hier nicht dargestellte flexible Platine ausgebildet, welche eine mit 7 bezeichnete Messeinrichtung, welche hier auf dem Rahmen 5 dargestellt ist, trägt. Diese Messeinrichtung 7 umfasst verschiedene Bauteile wie beispielsweise einen Hochsetzsteller und eine Einrichtung zur Erfassung der Spannung der Einzelzelle 3, mit deren Rahmen 5 sie verbunden ist. Vorzugsweise über federnde elektrische Kontakte 8 ist die auf der mit dem Rahmen 5 verbundenen oder durch diese ausgebildeten Flexplatine angeordnete Messeinrichtung 7 mit den beiden zur ihr benachbarten Bipolarplatten 6 elektrisch kontaktiert, und zwar auf der einen Seite mit der positiven und auf der andere Seite mit der negativen Oberfläche der entsprechenden Bipolarplatte 6. Hierdurch kann über die Messeinrichtung 7 die Spannung der ihr zugeordneten Einzelzelle 3 des Brennstoffzellenstapels 1 überwacht werden.

Für den Betrieb des Brennstoffzellenstapels 1 ist es nun wesentlich, zwischen verschiedenen Zuständen bei der Spannung zu unterschieden. Dies ist einerseits der Normalzustand, ein Zustand mit verringerter Zellspannung, welcher mit dem Begriff "Low Cell" bezeichnet wird, ein Zustand mit erhöhter Spannung, welcher als "High Cell" bezeichnet wird, und ein Zustand, bei dem eine elektrische Umpolung der Einzelzelle 3 stattgefunden hat. Dieser Zustand wird häufig auch mit dem englischen Begriff "Cell Reversal" bezeichnet. Für die Ansteuerung des Brennstoffzellenstapels 1 ist es nun von entscheidender Bedeutung, ob alle seine Einzelzellen 3 normal arbeiten oder ob eine oder mehrere der Einzelzellen einen der eben beschriebenen kritischen Zustände aufweisen, wobei die Zustände Low Cells und High Cells nicht ganz so kritisch sind wie der Zustand eines Cell Reversals.

Die Messeinrichtung 7 kann nun diese Zustände erfassen. Anders als bei herkömmlich aufgebauten Einrichtungen zur Überwachung der Spannung der Einzelzellen 3 des Brennstoffzellenstapels 1 hat die Messeinrichtung 7 in der hier beschriebenen Art mit der Integration auf dem Rahmen 5 den Vorteil, dass diese bei der Herstellung der Zelle unmittelbar mit eingebaut wird und nicht nachträglich installiert und eigens elektrisch kontaktiert werden muss. Um das Signal, in dem auch hinsichtlich des Explosionsschutzes aufgrund von möglichen Wasserstoffleckagen aus dem Brennstoffzellenstapel 1 kritischen Bereich sicher weiterzugeben, weist die Messeinrichtung 7 einen optischen Signalgeber 9 auf. Dieser optische Signalgeber 9 kann nun insbesondere die oben angesprochenen Zustände der Spannung der Einzelzelle 3 entsprechend darstellen, beispielsweise in dem er bei einer normalen Spannung ausgeschaltet bleibt und im einfachsten Falle bei einem der anderen Zustände leuchtet.

Eine Erfassung und Auswertung der Signale des optischen Signalgebers kann dann prinzipiell in der aus dem Stand der Technik bekannten Art und Weise beispielsweise über eine Reihe von Detektoren oder eine Umlenkung des Lichts zu einem hochauflösenden Detektor erfolgen. All dies ist prinzipiell denkbar, es ist jedoch hinsichtlich des benötigten Bauraums und der Kosten relativ aufwändig. Häufig, insbesondere bei Fahrzeuganwendungen, reicht es dabei aus, wenn bekannt ist, dass wenigstens eine der Einzelzellen 3 des Brennstoffzellenstapels 1 ein entsprechendes Problem hat. In diesem Fall muss reagiert werden, im Zweifel, indem der ganze Brennstoffzellenstapel 1 abgeschaltet wird oder indem seine Medienversorgung entsprechend geändert wird.

Die einfachste Variante des Aufbaus ist nun in der Darstellung der Figur 3 anhand eines Brennstoffzellenstapels 1 analog zu dem in Figur 1 entsprechend gezeigt. Die dargestellten Einzelzellen 3 weisen jeweils die Messeinrichtung 7 mit dem optischen Signalgeber 9 auf. Ein Lichtleiter 10, welcher als streifenförmiger Lichtleiter beispielsweise in der Querschnittsform eines Quaders ausgebildet ist, läuft in der Stapelrichtung s entlang des gesamten Brennstoffzellenstapels 1, und zwar so, dass die optischen Signalgeber 9 aller Messeinrichtungen 7 aller Einzelzellen 3 ihr Licht seitlich in eine Längsseite des Lichtleiters 10 einkoppeln. An zumindest einer oder optional an zwei Stirnseiten, und zwar vorzugsweise im Bereich der Stirnseiten, welchen den Endplatten 2 des Brennstoffzellenstapels 1 zugewandt sind oder in deren Bereich enden, sind nun optische Sensoren 11 angeordnet. Prinzipiell reicht ein optischer Sensor 11 aus. Bei einer entsprechend hohen Anzahl von Einzelzellen 3 und damit einer großen Länge des Brennstoffzellenstapels 1 in Stapelrichtung s kann es jedoch von Vorteil sein, im Bereich der zweiten Endplatte 2 einen weiteren optionalen optischen Sensor 11 mit vorzusehen, um so auch in dem Fall ein zuverlässiges Ergebnis zu erhalten, in dem nur eine Einzelzelle 3 über ihren optischen Signalgeber 9 der Messeinrichtung 7 ein Signal generiert, welches entlang der Stapelrichtung s relativ weit von nur einem optischen Sensor 11 entfernt ist und deshalb von diesem nicht zuverlässig detektiert werden kann.

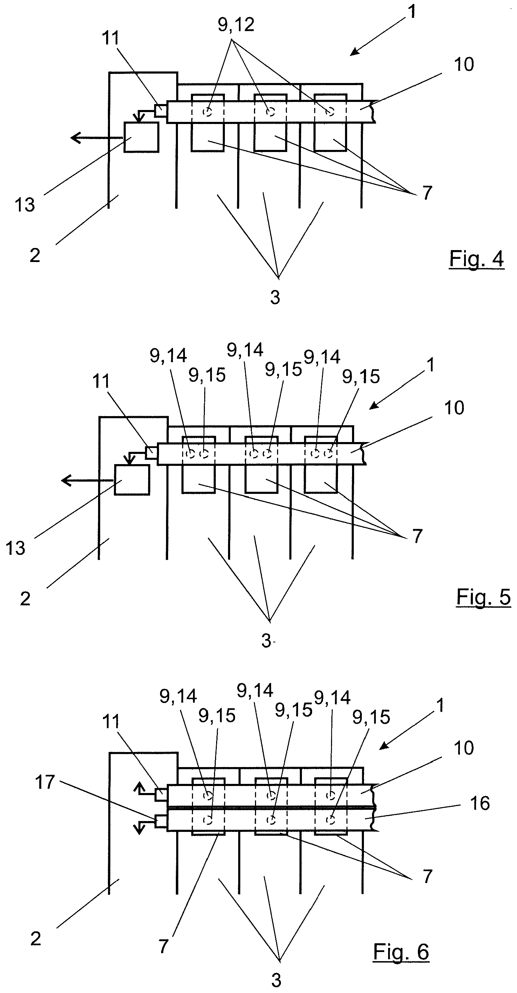

Wie oben bereits erwähnt kann es nun von Vorteil sein, wenn bekannt ist, ob über den optischen Sensor 11 das Problem einer Low Cell, einer High Cell und/oder das Problem eines Cell Reversals erkannt worden ist. Hierfür gibt es prinzipiell verschiedene Möglichkeiten, die in den nachfolgenden Darstellungen der Figuren 4 bis 7 entsprechend dargestellt und erläutert sind. Dabei ist jeweils ein Ausschnitt einer der Endplatten 2 mit drei Einzelzellen 3 und ihren Messeinrichtungen 7 dargestellt.

Im Falle der Darstellung in Figur 4 weist jede der Messeinrichtungen 7 dabei eine lichtemittierende Diode 12 als optischen Signalgeber 9 auf. Diese lichtemittierende Diode 12 ist als Multicolor-LED ausgebildet, welche verschiedene Farben darstellen kann. Bei einer normalen Spannung der jeweiligen Einzelzelle 3 bleibt sie ausgeschaltet. Bei einer Low Cell strahlt sie eine erste Farbe, beispielsweise gelb, ab, bei einer High Cell strahlt sie eine zweite Farbe, beispielsweise blau, ab, und bei einer in ihrer Polarität umgekehrten Zelle, also einem Cell Reversal, strahlt sie eine dritte Farbe, beispielsweise rot, ab. Über den einen oder optional zwei an den beiden Endplatten 2 angeordnete optische Sensoren 11 wird das abgestrahlte und von dem Lichtleiter 10 gesammelte und in den Bereich des Sensors 11 geleitete Licht nun aufgenommen und von einer Auswerteelektronik 13 entsprechend ausgewertet. In dieser Auswerteelektronik 13 kann insbesondere eine Fourier-Analyse erfolgen, um verschiedene Lichtfarben in dem vom Sensor 11 erfassten Licht zu analysieren. Ist das Licht lediglich einfarbig, liegt als beispielsweise gelbes Licht vor, dann kann über die Auswerteelektronik 13 das Problem einer oder mehrerer Low Cells weiter gemeldet werden. Enthält das Licht ausschließlich rotes Licht, könnte das Problem eines oder mehrerer Cell Reversals entsprechend weitergemeldet werden. Enthält das Licht ausschließlich blaues Licht, könnte das Problem einer oder mehrerer High Cells weitergemeldet werden. Enthält das Licht alle drei Lichtfarben, dann kann auch hier eine entsprechende Meldung, dass sowohl Low Cells als auch ein Cell Reversal vorliegt, entsprechend weitergereicht werden. Bezüglich der Hardware erfordert dies die Multicolor-LED 12 und bezüglich der Software eine entsprechende Auswertung in der Auswerteelektronik 13.

Alternativ oder prinzipiell auch ergänzend zu verschiedenen Lichtfarben ließen sich hier auch unterschiedliche Blinkfrequenzen oder -sequenzen, also Abfolgen bestimmter Blinkmuster, einsetzen, um die verschiedenen Zustände wenigstens einer der Einzelzellen 3 in dem Brennstoffzellenstapel 1 über den wenigstens einen optischen Sensor 11 erfassbar zu machen.

Der Aufbau lässt sich dahingehend verändern, dass auf die Multicolor-LED 12 gänzlich verzichtet werden kann. Der prinzipiell analog zur Darstellung in Figur 4 zu verstehende Aufbau in der Figur 5 sieht nun für jeden der optischen Signalgeber 9 beispielsweise zwei verschiedenfarbige lichtemittierende Dioden 14, 15 vor. Dies kann gegebenenfalls, bei ausreichend vorhandenem Bauraum, eine gegenüber dem Einsatz einer Multicolor-LED kostengünstigere Variante sein. Bei dieser Variante koppeln beide verschiedenfarbigen LEDs 14, 15 ihr Licht in derselben Art wie oben beschrieben in den Lichtleiter 10 ein. Die Erfassung über den wenigstens einen Sensor 11 und die Auswertung in der Auswerteelektronik 13 erfolgt dann analog. Die hier beispielhaft gezeigten zwei verschiedenen LEDs 14, 15 können also zusammen mit dem Zustand "ausgeschaltet" insgesamt drei Zustände weitergeben. Dies kann beispielsweise die normale Funktion sein, bei welcher beide LEDs 14, 15 ausgeschaltet sind, es kann das Problem einer High Cell oder Low Cell sein, bei welcher eine der LEDs, zum Beispiel die LED 14, eingeschaltet ist, und es kann das Problem eines Cell Reversals sein, bei welcher beispielsweise die LED 15 eingeschaltet ist. Selbstverständlich ließe sich dieser Aufbau mit einer dritten LED entsprechend erweitern, um so in dem bei dem wenigstens einen optischen Sensor 11 ankommenden Signal auch noch zwischen dem Zustand High Cell und Low Cell unterscheiden zu können.

Ferner ist in der Darstellung der Figur 6 eine weitere Variante gezeigt. Statt die LEDs 14, 15 beispielsweise in Stapelrichtung benachbart in jeder der Messeinrichtungen 7 als optische Signalgeneratoren anzuordnen, können diese auch quer zur Stapelrichtung versetzt angeordnet werden, und zwar so, dass sie, wie es in der Darstellung der Figur 6 zu erkennen ist, ihr Licht in zwei parallel verlaufende Lichtleiter 10, 16 einkoppeln. Sie können dabei verschiedenfarbig sein, es können jedoch auch lauter gleichfarbige LEDs eingesetzt werden. In diesem Fall ist es so, dass beispielsweise die in der Darstellung der Figur 6 oben dargestellten LEDs 14 für den Fall, dass sie aktiviert sind, eine Low Cell oder High Cell anzeigen, die im Bereich des zweiten Lichtleiters 16 in der Darstellung der Figur 6 unten angeordneten LEDs 15 des optischen Signalgebers 9 ein Cell Reversal. Über den optischen Sensor 11 kann dann in an sich bekannter Weise, ohne dass eine weitere Auswertung bezüglich der Lichtfarben notwendig ist, direkt das Problem Low Cells angezeigt und an die entsprechenden Steuereinrichtungen weitergegeben werden, über einen optischen Sensor 17 an der Stirnseite des anderen Lichtleiters 16 dementsprechend das Problem eines oder mehrerer Cell Reversals.

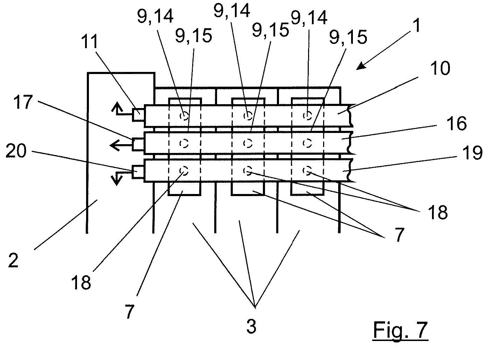

Auch dieser in Figur 6 dargestellte Aufbau lässt sich nun, wie es oben prinzipiell bereits beschrieben worden ist, über die zwei LEDs 14, 15 hinaus um eine dritte LED 18, und in diesem Fall auch dementsprechend über einen weiteren Lichtleiter 19 und einen weiteren optischen Sensor 20 entsprechend erweitern. Dies ist in der Darstellung der Figur 7, welche ansonsten analog zur Darstellung der Figuren 4 bis 6 zu verstehen ist, entsprechend dargestellt. Mit diesem Aufbau ließe sich dann in jedem einzelnen der Lichtleiter 10, 16, 19 jeweils einer der interessanten Zustände entsprechend anzeigen.

Insgesamt ist der Aufbau bei allen Varianten außerordentlich einfach und kommt mit wenigen optischen Sensoren 11, 17, 20 aus, welche ihrerseits lediglich das Vorhandensein von Licht sowie gegebenenfalls die Lichtfarbe erkennen müssen, und an welche keine hohen Anforderungen beispielsweise hinsichtlich einer hohen Pixelauflösung oder dergleichen zu stellen sind.

Die Aufbauten eignen sich prinzipiell für jede Art von Brennstoffzellenstapel 1, insbesondere für PEM-Brennstoffzellen. Sie sind besonders günstig für den Fahrzeugeinsatz derartiger Brennstoffzellenstapel 1, da hier die Verhältnisse bezüglich der Bauraumbeschränkung einerseits und eines sehr starken Kostendrucks bei der Montage und der Herstellung der Brennstoffzellenstapel 1 andererseits zu erfüllen sind.

Die Vorrichtungen zur Überwachung der Zellspannung in den beschriebenen möglichen Ausführungsvarianten ermöglichen dies ideal.

## Patentansprüche

1. Vorrichtung zur Überwachung der Zellspannung von durch eine Membranelektrodenanordnung (4) und Bipolarplatten (6) gebildeten Einzelzelle (3) eines Brennstoffzellenstapels (1), mit einer Messeinrichtung (7) für jede der Einzelzellen (3), welche einen von ihr ansteuerbaren optischen Signalgeber (9) umfasst, wobei
die Messeinrichtung (7) auf einer flexiblen Platine ausgebildet ist, welche mit einem Rahmen (5) einer gerahmten Membranelektrodenanordnung (4, 5) verbunden oder als Teil desselben ausgebildet ist, und
der optische Signalgeber (9) jeder Messeinrichtung (7) durch eine lichtemittierende Diode (12) ausgebildet ist, welche dazu eingerichtet ist, Licht in wenigstens zwei Lichtfarben abzustrahlen.

2. Vorrichtung nach Anspruch 1,
**dadurch gekennzeichnet, dass**
die Messeinrichtung (7) über flexible Leiterelemente und/oder Federkontakte (8) mit den beiden benachbarten Bipolarplatten (6) elektrisch leitend verbunden ist.

3. Vorrichtung nach Anspruch 1 oder 2,
**dadurch gekennzeichnet, dass**
die Messeinrichtung (7) einen Hochsetzsteller umfasst.

4. Vorrichtung nach einem der Ansprüche 1 bis 3,
**dadurch gekennzeichnet, dass**
der optische Signalgeber (9) in der Art ausgebildet ist, dass er von der Messeinrichtung (7) mit wenigstens drei sich unterscheidenden Zuständen ansteuerbar ist.

5. Vorrichtung nach einem der Ansprüche 1 bis 4.
**dadurch gekennzeichnet, dass**
die optischen Signalgeber (9) aller Messeinrichtungen (7) über wenigstens einen Lichtleiter (10, 16, 19) mit wenigstens einem optischen Sensor (11) verbunden sind.

6. Vorrichtung nach Anspruch 5,
**dadurch gekennzeichnet, dass**
eine Auswerteelektronik (13) zur Auswertung der Daten des wenigstens einen Sensors (11) vorgesehen ist, welcher dazu eingerichtet ist, die erfassten Signale hinsichtlich des Auftretens bestimmter Farben und/oder Blinkfrequenzen auszuwerten.

## Claims

1. An apparatus for monitoring the cell voltage of an individual cell (3), formed by a membrane electrode assembly (4) and bipolar plates (6), of a fuel cell stack (1), having a measuring device (7) for each of the individual cells (3), which comprises an optical signal generator (9) which can be controlled by it, wherein
the measuring device (7) is formed on a flexible circuit board which is connected to a frame (5) of a framed membrane electrode assembly (4, 5) or formed as part of the same, and
the optical signal generator (9) of each measuring device (7) is formed by a light-emitting diode (12), which is set up to emit light in at least two light colors.

2. The apparatus according to claim 1,
**characterized in that**
the measuring device (7) is electrically conductively connected to the two adjacent bipolar plates (6) via flexible conductor elements and/or spring contacts (8).

3. The apparatus according to claim 1 or 2,
**characterized in that**
the measuring device (7) comprises a step-up converter.

4. The apparatus according to one of claims 1 to 3,
**characterized in that**
the optical signal generator (9) is formed in such a way that it can be controlled by the measuring device (7) with at least three different states.

5. The apparatus according to one of claims 1 to 4,
**characterized in that**
the optical signal generators (9) of all measuring devices (7) are connected to at least one optical sensor (11) via at least one light guide (10, 16, 19).

6. The apparatus according to claim 5,
**characterized in that**
an evaluation electronics (13) for evaluating the data of the at least one sensor (11) is provided, which is set up to evaluate the detected signals with regard to the occurrence of specific colors and/or flashing frequencies.

## Revendications

1. Dispositif de surveillance de la tension de cellule d'une cellule individuelle (3) d'un empilement de piles à combustible (1) formée par un ensemble d'électrodes à membrane (4) et de plaques bipolaires (6), avec un système de mesure (7) pour chacune des cellules individuelles (3), qui comprend un émetteur de signal optique (9) pouvant être piloté par celui-ci, dans lequel
le système de mesure (7) est réalisé sur une platine flexible qui est reliée à un cadre (5) d'un ensemble d'électrodes à membrane encadré (4, 5) ou qui est réalisée comme une partie de celui-ci, et
l'émetteur de signal optique (9) de chaque système de mesure (7) est réalisé par une diode électroluminescente (12) qui est mise au point pour émettre de la lumière dans au moins deux couleurs de lumière.

2. Dispositif selon la revendication 1,
**caractérisé en ce que**
le système de mesure (7) est relié de manière électriquement conductrice aux deux plaques bipolaires (6) adjacentes par l'intermédiaire d'éléments conducteurs flexibles et/ou de contacts à ressort (8).

3. Dispositif selon la revendication 1 ou 2,
**caractérisé en ce que**
le système de mesure (7) comprend un convertisseur élévateur.

4. Dispositif selon l'une quelconque des revendications 1 à 3,
**caractérisé en ce que**
l'émetteur de signal optique (9) est réalisé de telle sorte qu'il peut être piloté par le système de mesure (7) avec au moins trois états différents.

5. Dispositif selon l'une quelconque des revendications 1 à 4.
**caractérisé en ce que**
les émetteurs de signal optiques (9) de tous les dispositifs de mesure (7) sont reliés par au moins un câble optique (10, 16, 19) à au moins un capteur optique (11).

6. Dispositif selon la revendication 5,
**caractérisé en ce que**
une électronique d'évaluation (13) est prévue pour l'évaluation des données de l'au moins un capteur (11) qui est mis au point pour évaluer les signaux détectés en ce qui concerne l'apparition de certaines couleurs et/ou fréquences de clignotement.
